# EUROPEAN PATENT APPLICATION

(11) **EP 4 791 172 A1**
(43) Date of publication of application: **12.08.2026**
(21) Application number: 25156013.2
(22) Date of filing: 05.02.2025
(51) Int. Cl.: H10N 30/88, H10N 30/50

(54) **STACKED DIELECTRIC ELASTOMER ACTUATOR ASSEMBLY WITH THERMAL COMPENSATION**

(71) Applicant: Dätwyler Schweiz AG, 6467 Schattdorf (CH)
(72) Inventor: Düring, Lukas, 9545 Wängi (CH); Albuquerque, Fabio Beco, 6452 Sisikon (CH); Nejati, Morteza, 8041 Zürich (CH)
(74) Representative: Prins Intellectual Property AG

(57) **Abstract**

An actuator assembly (1) comprises a stacked dielectric elastomer actuator (2) arranged within a support structure (3) having a thermal compensation section (33) which includes a plurality of alternating first subsections (33a) of a first material and second subsections (33b) of a second material. The first material has a lower coefficient of thermal expansion than the second material. The subsections are attached to each other such that a first subsection restricts the thermal expansion of a second subsection in a direction perpendicular to the stroke direction (L) and thereby enlarges thermal expansion of the second subsection in a direction parallel to the stroke direction. The coefficients of thermal expansion of the first and second materials are selected such that at any temperature within a predefined operating temperature range the thermal expansion of the support structure in stroke direction is approximately equal to the thermal expansion of the stacked actuator in stroke direction.

## Description

### Technical Field

The invention relates to an assembly including stacked dielectric elastomer actuator (SDEA) for implementation in an SDEA-based actuator system or actuator device.

### Technical Background

An actuator is a component of a machine that produces force, torque, or displacement, usually in a controlled way, when an electrical, pneumatic or hydraulic input is supplied to it in a system (called an actuating or actuator system). An actuator converts such an input signal into the required form of mechanical energy. Electro-mechanical actuators converting electrical energy into mechanical force are also called transducer. Electro-mechanical actuators are for example solenoids, piezoelectric devices, or electroactive polymers (EAP).

Dielectric elastomers actuators (DEA) are a class of electroactive polymers (EAP), which principle of work is based on the compression of an elastomeric film sandwiched between two compliant electrodes. When a voltage is applied to the electrodes, the arising electric field causes a decrease in thickness and increase in area of the elastomeric film. The elastomer film moves back to its original position when the electrodes are short-circuited. DEA can transform electric energy into mechanical work and vice versa. In a so-called stacked (or multi-layered) dielectric elastomer actuator (SDEA) a plurality of dielectric and electrode layers are alternately stacked to increase the actuation stroke length.

SDEAs constitute an excellent alternative to conventional actuator technologies such as DC motors, solenoid electromagnets, magnetic technologies and piezoelectric systems. Stacked dielectric elastomer actuators provide a lightweight, compact, noiseless and easy to assemble solution with low complexity (no need of gears), low maintenance and high lifetime.

Due to the nature of the elastomeric material used, SDEAs intrinsically possess non-negligible thermal expansion which means that the actuator will exhibit different initial lengths as a function of temperature. This thermal behaviour is particularly relevant for applications, such as valves, pumps, latching and lock systems or haptic feedback interfaces, where precise strokes must be ensured across a broad range of temperatures. Thus, for some applications there is a need to compensate for the intrinsic thermal behaviour of SDEAs.

In an ideal case, all parts of the actuator assembly are of a material having the same coefficient of thermal expansion (CTE). This, however, is rarely possible.

WO2005053045 addresses a similar problem of electro-mechanical actuator based on a piezoelectric ceramic multilayer actuator (piezoelectric CMA) and describes an actuator assembly including the piezoelectric CMA and a rigid, non-flexing support structure for the piezoelectric CMA. Part of the material of the rigid, non-flexing, support structure may be replaced with an element made from a material with a coefficient of thermal expansion (CTE) capable of compensating for the thermal expansion mismatch between the materials of the support structure and the piezoelectric CMA. Thus, some parts of the rigid, non-flexing support structure have larger CTE than the piezoelectric CMA and some parts have a lower CTE than the piezoelectric CMA.

US5205147 provides a similar solution for a piezoelectric actuator. A case around the piezoelectric element is formed with two kinds of material, one having a lower CTE and the other having a higher CTE than that of the piezoelectric element.

US6313568 describes a piezoelectric actuator assembly that is insensitive to wide variation in operating temperatures. The assembly includes a stack of piezoelectric devices and a surrounding housing assembly formed of an outer cylindrical housing portion formed of steel having a coefficient of thermal expansion above that of the piezoelectric material and an inner cylindrical housing portion formed of Si-Ni ceramic. By arranging the inner and outer housing portions in parallel and forming the housing portions with appropriate cross-sectional areas, the housing assembly will have an effective coefficient of thermal expansion that is equivalent to that of the piezoelectric element.

US4284263 describes a control valve having the actuating member supported within a housing. The actuating member includes an elongated piezoelectric element having a relatively low thermal coefficient of expansion. The housing is made from common, inexpensive materials having moderately higher thermal coefficient of expansion, and the actuating member includes a spacer having a high thermal coefficient of expansion, arranged between the closed housing end and the piezoelectric element. By proper dimensioning of the spacer and housing with respect to the piezoelectric element, temperature compensation may be achieved without the use of exotic materials.

### Summary of the Invention

It is an objective of the invention to provide an actuator assembly with a stacked dielectric elastomer actuator that functions correctly over large temperature changes of more than 40°C (or over a large temperature range covering a range from below 0°C to above 40°C).

The inventors realized that all known solutions based on piezoelectric actuators require parts of the housing having a larger CTE than the piezoelectric actuator. Elastomers, however, have a considerably large CTE as compared to materials used in piezoelectric actuators. Thus, the effective coefficient of thermal expansion of an SDEA is about 10x to 100x larger than the effective coefficient of thermal expansion of a piezoelectric actuator. It is hardly possible to find a material providing a larger CTE than the effective CTE of an SDEA and at the same time provide a rigid and stable support structure for the SDEA.

At least one of the objectives of the present invention is achieved by an actuator assembly according to claim 1 and an actuator system according to claim 12.

The actuator assembly comprises a stacked dielectric elastomer actuator (SDEA) arranged within a support structure. The support structure has a base end and a top end opposite the base end, said top end being provided with a mounting portion for mounting the support structure to a structural component of an actuator system. The stacked actuator has a static end and a dynamic end opposite the static end, said dynamic end defining a displacement surface, which is displaceable in a linear stroke direction of the stacked actuator. The stacked actuator is placed within the support structure with the static end being supported in a fixed position by the base end of the support structure and with the displacement surface of the dynamic end arranged near the top end of the support structure. The support structure comprises a thermal compensation section including a plurality of alternating first subsections of a first material and second subsections of a second material alternately lined up in the stroke direction. The first material has a lower coefficient of thermal expansion (CTE) than the second material. The first and second subsections are attached to each other, such that the first subsection restricts the thermal expansion of the second subsection in a direction perpendicular to the stroke direction and thereby enhances the thermal expansion of the second subsection in a direction parallel to the stroke direction. The coefficient of thermal expansion of the first material and the second material are selected such that at any temperature within a predefined operating temperature range the thermal expansion of the support structure in stroke direction is equal to the thermal expansion of the stacked actuator in stroke direction.

The actuator assembly may be mounted in an actuator system or device by fixing the mounting portion of the support structure to a structural component (i.e. a static rigid part, e.g. a housing) of the actuator system. The dynamic end of SDEA with the displacement surface may be operatively connected to a part of the actuator system, which is to be displaced within the actuator system. The base end of the support structure is moveably arranged within the actuator system, such that support structure and the SDEA can adjust to temperature changes. The displacement surface, which is accessible from outside the support structure, may be provided with different parts for different applications, e.g. a sealing component of a valve, a piston or membrane in a pump or dosing device, an interlocking element in a lock or a part of a haptic feedback interface.

The coefficient of thermal expansion (CTE) is a characteristic of a material (e.g. elastomer, thermoplastics, metal, etc.). The thermal expansion of a part, e.g. the stacked dielectric elastomer actuator or the support structure results from a combination of materials, which may have different CTE. A stacked dielectric elastomer actuator is made for large part of elastomers and the thermal expansion results mainly from the CTE of the elastomer.

With the support structure having alternating sections made of material with different CTE, the thermal expansion of the support structure may be higher than the coefficients of thermal expansion of the first and second material. This is possible, because upon increasing temperatures the first and second subsections, which may be stacked in stroke direction and attached to each other at opposite ends perpendicular to the stroke direction, expand differently. The first subsection with the lower CTE restricts the expansion of the second subsection with the higher CTE in the direction perpendicular to the stroke direction of the stacked actuator. Thereby, the second subsection is forced to expand more in the direction parallel to the stroke direction. Thus, the resulting thermal expansion of the support structure holding the SDEA is essentially equal to thermal expansion of the SDEA over a large operating temperature range. In other words, the relative position of the displacement surface of the SDEA and the mounting portion of the support structure remain the same, independent of temperature changes.

Further embodiments of the invention are set forth in the dependent claims.

In some embodiments, the first material may have a coefficient of thermal expansion in the range of up to 100 µm/m/K and the second material may have a coefficient of thermal expansion in the range of 50 to 200 µm/m/K. An elastomer of the stacked dielectric elastomer actuator may have a coefficient of thermal expansion in the range of 300 to 400 µm/m/K.

In some embodiments, the support structure may have at least two opposite side structures each connecting the base end with the mounting portion at the top end and comprising the compensation section. The support structure may be a cage, casing or the like. It may be open on two sides or closed on all sides. The top end may be an open end.

The base end of the support structure may be a plate or a grid. It may be provided with at least one opening for electrical contacts. It may be formed by a rigid printed circuit board providing electrical contact for the SDEA.

The dynamic end of the SDEA may be even with, extend over or extend below the mounting portion of the support structure.

Typically, the static end of the SDEA is attached to the base end of the support structure. In some applications it may abut against the base end. The dynamic end of the SDEA is typically freely moveable in stroke direction when operating the SDEA. The dynamic end may be guided in a guiding.

In some embodiments, the length of the compensation section corresponds approximately to the height of the SDEA from the static end to the dynamic end. The CTE of the materials of the subsections are then chosen to result in a thermal expansion of the compensation section corresponding to the thermal expansion of the SDEA. The compensation section may also be longer or shorter than the SDEA.

In some embodiments, the first subsection may have a bar-like shape. The first subsection may extend perpendicular to the stroke direction and may have opposite distal ends connected to the second subsection.

In some embodiments, the second subsection may have on each of two opposite ends a pair of legs extending at an angle to the stroke direction, wherein proximal ends of the pair of legs are connected to each other and distal ends of the pair of legs are connected to distal ends of adjacent first substructures. The second subsection may have a central bar connecting two opposite pair of legs to each other.

Thus, the alternating first and second subsections may be shaped and connected to each other to enhance a thermal expansion in stroke directions although the CTE of the materials of the subsections are smaller than the CTE of the elastomers of the SDEA.

In other words, in a variant of the thermal compensation section, the second subsection may have a central bar with two legs at each end connected to opposite ends of an upper and a lower first subsection. An increase in temperature leads to thermal expansion of the first and second subsection. The material of the first subsection has a lower CTE than the material of the second subsection and thus restricts the thermal expansion of the second subsection perpendicular to the stroke direction. Thereby the distal ends of the legs of the second subsection are forced apart in stroke direction resulting in enhanced thermal expansion in stroke direction of the SDEA.

In some embodiments, the support structure may be made of a rigid, non-elastomeric material. The support structure may withstand forces generated by the stacked dielectric elastomer actuator. Dimensional changes of the support structure occur only due to temperature changes but not due to operation of the SDEA.

In some embodiments, electrical contacts to the SDEA may be provided at the base end of the support structure. The electrical contacts, e.g. wires, can freely move together with the base end of the support structure upon changes in temperature.

In some embodiments, the predefined operating temperature range may extend over at least 40°C, preferably at least 60°C. The predefined operating temperature range may cover a range from below 0°C to above 40°C. The predefined operating temperature range may be e.g. approx. - 40°C to approx. 90°C.

The invention further relates to an actuator system or actuator device comprising an actuator assembly according to one of the preceding claims, an actuator housing with a structural component, wherein the mounting portion of the support structure is attached to the structural component of the actuator system and the base end is freely moveable within the actuator housing.

In some embodiments, the actuator system further comprises electrical contacts for electrically contacting the static end of the stacked dielectric elastomer actuator.

In some embodiments, the displacement surface of the stacked dielectric elastomer actuator may be operatively connected to a thrust element of the actuator system. The thrust element may be a sealing component of a valve, a piston or membrane in a pump or dosing device, an interlocking element in a lock or part of a haptic feedback interface.

In some embodiments, the actuator assembly may be provided with guiding elements to prevent buckling of the stacked actuator. The guiding elements may stabilize the support structure without hindering its moveability or thermal expansion in stroke direction.

In some embodiments, the actuator assembly is provided with thermal insulation and/or electrical shielding.

In some embodiments, the actuator system may comprise several actuator assemblies or the actuator assembly may comprise several SDEA.

### Brief Explanation of the Figures

The invention is described in greater detail below with reference to embodiments that are illustrated in the figures. The figures show:
- Fig. 1: a schematic representation of the principal of thermal expansion compensation of an actuator assembly;
- Fig. 2: an embodiment of an actuator assembly having a support structure with a thermal compensation section;
- Fig. 3: a perspective view of the support structure of Fig. 2;
- Fig. 4: a side view of the support structure of Fig. 2.

### Embodiments of the Invention

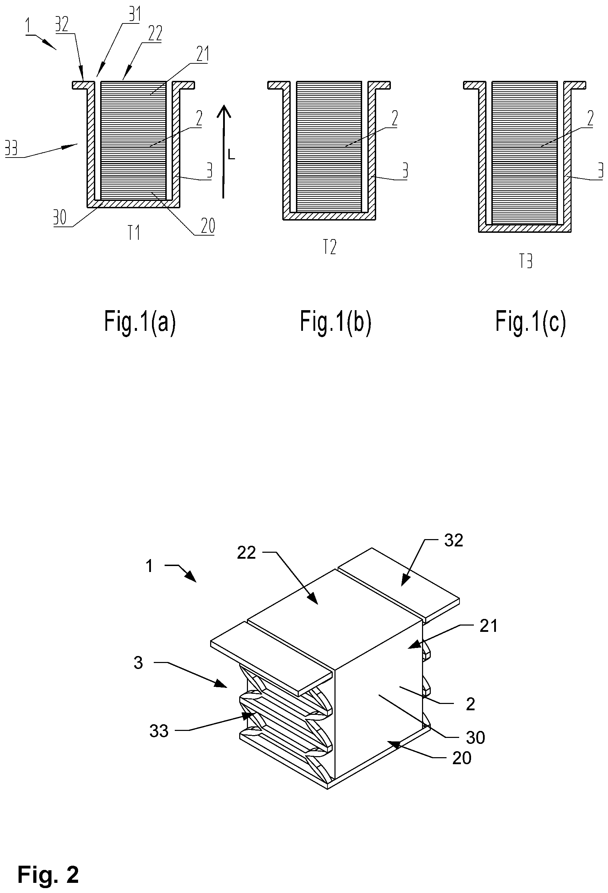

Fig. 1 shows a schematic representation of the principle of thermal expansion compensation of an actuator assembly 1. Fig. 2 shows an example of an actuator assembly with thermal expansion compensation.

The actuator assembly 1 comprises a stacked dielectric elastomer actuator 2 (SDEA, or stacked actuator) and a support structure 3. The stacked actuator 2 has a plurality of alternately stacked dielectric elastomer and electrode layers. When a voltage is applied to the electrode layers, the arising electric field causes a decrease in thickness of the elastomeric layer perpendicular to the plane of the layers. Thus, the stacked actuator 2 may change its length in a stroke direction L, between a static end 20 and a dynamic end 21 of the stacked actuator 2.

The stacked actuator 2 is arranged within and supported by the support structure 3. The support structure 3 comprises a base end 30 and a top end 31 opposite the base end 30. The top end 31 is provided with a mounting portion 32 for mounting the support structure 3 in a actuator system or actuator device.

The static end 20 of the stacked actuator 2 is attached to the support structure at its base end 30. The dynamic end 21 forms a displacement surface 22 and is arranged at the top end 31 of the support structure 3.

The support structure 3 further comprises a thermal compensation section 33 connecting the base end 30 of the support structure 3 with the mounting portion 32 of the support structure 3. The thermal compensation section 33 is designed such that the thermal expansion of the support structure 3 is equal to the thermal expansion of the stacked actuator 2 over a predefined temperature range T1 to T3. Fig. 1(a) shows the actuator assembly 1 at a low temperature T1 of e.g. minus 40°C. In the shown example the displacement surface 22 of the stacked actuator 2 is flush with the mounting surface 32 of the support structure 3. With increasing temperature to T2 of e.g. 20°C (Fig. 1 (b)) and to T3 of e.g. 80°C (Fig. 1(c)) the stacked actuator starts to continuously thermally expand. Because the support structure 3 shows the same behaviour of thermal expansion, the relative position of the displacement surface 22 of the stacked actuator 2 and the mounting portion 32 of the support structure 3 remains the same. With different thermal expansion of the stacked actuator 2 and the support structure 3 the displacement surface 22 would be lower or higher than the mounting surface 32 at different temperatures.

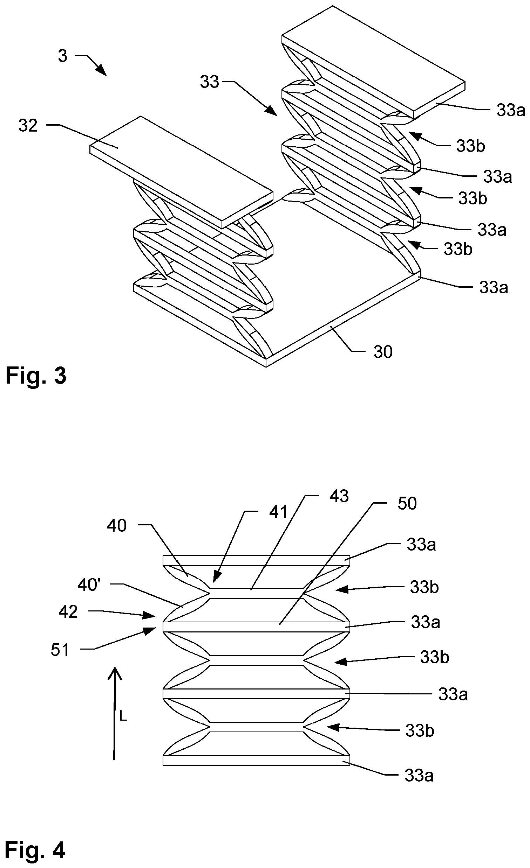

Fig. 2 shows an actuator assembly having a support structure 3 with a thermal compensation section 33 connecting the base end 30 of the support section 3 with mounting portions 32 of the support section 3. Fig. 3 shows a perspective view of the support structure 3 of Fig. 2. Fig. 4 shows a side view of the support structure of Fig. 2.

In the shown embodiment one thermal compensation section 33 is arranged at opposite sides of the stacked actuator 2 extending in stroke direction L. The thermal compensation sections 33 comprise a plurality of alternating first subsections 33a of a first material and second subsections 33b of a second material alternately lined up in the stroke direction L. The first material of the first subsection 33a is chosen to have a lower coefficient of thermal expansion (CTE) than the CTE of the second material of the second subsection 33b. The first subsections 33a and second subsections 33b are connected to adjacent subsections at least at their distal ends. Thereby, the first subsection 33a with the lower CTE restricts thermal expansion of the second subsection 33b perpendicular to the stroke direction forcing the second subsection to enhanced expansion in stroke direction. By that principle of combining first and second subsections with materials having a different CTE, thermal expansion can be enhanced in a desired direction to reach the thermal expansion of the elastomer of the stacked actuator 2.

The coefficient of thermal expansion of the first material and the second material are selected such that at any temperature T1, T2, T3 within a predefined operating temperature range the thermal expansion of the support structure 3 in stroke direction L is equal to the thermal expansion of the stacked actuator 2 in stroke direction L such that the distance between the top end 31 and the displacement surface 22 remains the same.

In the embodiment of Fig. 2 to Fig. 4, this behaviour is achieved by a first subsection 33a shaped as a bar 50 and a second subsection 33b having on each of two opposite ends a pair of legs 40, 40' extending at an angle to the stroke direction L. Proximal ends 41 of the pair of legs 40, 40' are connected to each other and distal ends 42 of the pair of legs 40, 40' are connected to distal ends 51 of adjacent first substructures 33a. The second subsection 33b may have a central bar 43 connecting two opposite pair of legs 40, 40' to each other.

### Reference Signs

- 1: actuator assembly
- 2: stacked dielectric elastomer actuator
- 20: static end
- 21: dynamic end
- 22: displacement surface
- 3: support structure
- 30: base end
- 31: top end
- 32: mounting portion
- 33: compensation section
- 33a: first subsection
- 33b: second subsection
- 40: leg
- 41: proximal end
- 42: distal end
- 43: central bar
- 50: bar
- 51: distal end
- L: linear stroke direction / direction of linear displacement
- T1, T2, T3: temperature

## Claims

1. Actuator assembly (1) comprising a stacked dielectric elastomer actuator (2) arranged within a support structure (3);
wherein the support structure (3) has a base end (30) and a top end (31) opposite the base end (30), said top end (31) being provided with a mounting portion (32) for mounting the support structure (3) to a structural component of an actuator system;
wherein the stacked actuator (2) has a static end (20) and a dynamic end (21) opposite the static end (20), said dynamic end (21) defining a displacement surface (22), which is displaceable in a linear stroke direction (L) of the stacked actuator (2);
wherein the stacked actuator (2) is placed within the support structure (3) with the static end (20) being supported in a fixed position by the base end (30) of the support structure (3) and with the displacement surface (22) of the dynamic end (21) arranged near the top end (31) of the support structure (3); and
wherein the support structure (3) comprises a thermal compensation section (33) including a plurality of alternating first subsections (33a) of a first material and second subsections (33b) of a second material alternately lined up in the stroke direction (L);
wherein the first material has a lower coefficient of thermal expansion than the second material;
and wherein the first and second subsections (33a, 33b) are attached to each other, such that the first subsection (33a) restricts the thermal expansion of the second subsection (33b) in a direction (D1) perpendicular to the stroke direction (L) and thereby enhances the thermal expansion of the second subsection (33b) in a direction (D2) parallel to the stroke direction (L);
wherein the coefficient of thermal expansion of the first material and the second material are selected such that at any temperature (T1, T2, T3) within a predefined operating temperature range the thermal expansion of the support structure (3) in stroke direction (L) is equal to the thermal expansion of the stacked actuator (2) in stroke direction (L).

2. Actuator assembly according to claim 1, wherein the first material has a coefficient of thermal expansion in the range of up to 100 µm/m/K and the second material has a coefficient of thermal expansion in the range of 50 to 200 µm/m/K.

3. Actuator assembly according to claim 1, wherein an elastomer of the stacked dielectric elastomer actuator has a coefficient of thermal expansion in the range of 300 to 400 µm/m/K.

4. Actuator assembly according to one of the preceding claims, wherein the support structure (3) has at least two opposite side structures each connecting the base end (30) with the mounting portion (32) at the top end (31) and comprising the compensation section (33).

5. Actuator assembly according to one of the preceding claims, wherein the first subsection (33a) has a bar-like shape.

6. Actuator assembly according to one of the preceding claims, wherein the first subsection extends in a direction perpendicular to the stroke direction and has opposite distal ends connected to the second subsection.

7. Actuator assembly according to one of the preceding claims, wherein the second subsection (33b) has on each of two opposite ends a pair of legs extending at an angle to the stroke direction, wherein proximal ends of the pair of legs are connected to each other and distal ends of the pair of legs are connected to distal ends of adjacent first substructures.

8. Actuator assembly according to claim 7, wherein the second subsection has a central bar connecting two opposite pair of legs to each other.

9. Actuator assembly according to one of the preceding claims, wherein the support structure (3) is made of a rigid, non-elastomeric material.

10. Actuator assembly according to one of the preceding claims, wherein electrical contacts to the stacked dielectric elastomer actuator (2) are provided at the base end (30) of the support structure (3).

11. Actuator assembly according to one of the preceding claims, wherein the predefined operating temperature range extends over at least 40°C, preferably at least 60°C.

12. Actuator system comprising an actuator assembly according to one of the preceding claims, an actuator housing with a structural component, wherein the mounting portion of the support structure is attached to the structural component of the actuator system and the base end is freely moveable within the actuator housing.

13. Actuator system according to claim 12, wherein the displacement surface of the stacked dielectric elastomer actuator is operatively connected to a thrust element of the actuator system.

14. Actuator system according to one of claims 12 to 13, wherein the actuator assembly is provided with guiding elements to prevent buckling of the stacked actuator.

15. Actuator system according to one of claims 12 to 14, wherein the actuator assembly is provided with thermal insulation and/or electrical shielding.
